# EUROPEAN PATENT APPLICATION

(11) **EP 4 823 286 A1**
(43) Date of publication of application: **14.10.2026**
(21) Application number: 25170238.7
(22) Date of filing: 13.04.2025
(51) Int. Cl.: H10F 77/42, H10F 77/40

(54) **SOLAR CONCENTRATOR PANEL ENHANCED THROUGH CONCENTRATION AND FOCUSED REFLECTION, WITH OR WITHOUT LUMINESCENCE (LSC)**

(30) Priority: 11.04.2025 IT 202500001554 U
(71) Applicant: PAMA srl, 60037 Monte San Vito (AN) (IT)
(72) Inventor: ROMAGNOLI, Claudio, 60019 Ancona Senigallia (IT)

(57) **Abstract**

The invention relates to the development of an enhanced luminescent solar concentrator panel employing a unique method for capturing and concentrating the maximum amount of solar energy in a specific area using an "inverse" focusing effect. The solution involves a luminescent solar panel that absorbs all incident energy without dispersion in the opposite wall (no semitransparency).

This type of enhanced luminescent solar concentrator operates with sunlight and consists of a transparent material, an intermediate zone made up of a diffusive layer and multiple internally reflecting and focusing cones, a horizontal discontinuous reflective layer beneath the cones, a second reflective layer at the panel's base, and photovoltaic strips positioned along the lateral edges of the transparent portion.

Sunlight striking the panel is diffused by the pigment and trapped underneath through a funnel-shaped zone directed by an inverse optical lens. Thanks to reflection between the intermediate layer and the lower reflective base of the panel, the trapped light remains concentrated and is transferred by reflection to the photovoltaic elements.

This invention is innovative because it enables the creation of an enhanced luminescent solar concentrator (LSC) panel that absorbs the majority of incident energy while reducing losses. This application is highly effective as it can be used as a cladding for opaque surfaces (non-glazed) for green energy generation, and it is also suitable for Agrivoltaic applications.

This result is achieved without the need for expensive materials and/or equipment, thanks to the synergies between the constituent parts, making the invention immediately suitable for industrialization.

## Description

### a. FIELD OF THE INVENTION

The present invention is intended for applications in the field of green energy production, specifically related to urban, commercial, and industrial buildings.

It can be applied to both vertical and horizontal surfaces of architectural and non-architectural structures, as it is designed to function as a **building cladding system capable of generating energy.**

### b. DESCRIPTION OF THE STATE OF THE ART

Luminescent solar concentrators (LSCs) have been developed to harness solar energy in a different manner compared to conventional photovoltaic panels, with the aim of reducing overall system costs by optimizing the use of the photovoltaic cell, which represents the most expensive component of the system.

The operating principle is based on the concentration of light radiation towards the lateral edges of the panel, in a way that differs from the approach used by large-scale solar concentrators that focus light, employing instead a waveguide-like effect.

In their standard configuration, these luminescent concentrators consist of a glass plate "doped" with fluorescent dye molecules. These dyes absorb light at specific wavelengths from the incident solar radiation and re-emit it in all directions at longer wavelengths. A portion of this re-emitted light falls within the critical angle of the waveguide and is totally internally reflected, allowing it to be transported to the lateral-mounted photovoltaic module. However, current luminescent concentrators suffer from low efficiency due to significant reabsorption of the emitted light, poor light coupling into the waveguide, and, more generally, difficulty in retaining light within the waveguide structure.

### c. TECHNICAL PROBLEMS

Currently, luminescent solar concentrator panels exhibit efficiency issues caused by several factors, including reabsorption and general light dispersion. Another limiting factor in applications where luminescent concentrators are used in place of glazed walls is the requirement for partial transparency. As a result, a significant portion of the incident light radiation passing through a wall is transmitted to the opposite surface, inherently reducing the amount of useful energy that can be concentrated.

These concentrators are typically composed of a matrix embedded with luminescent materials. The incident solar radiation is converted through a luminescent process as soon as it interacts with this material and can subsequently be harvested by a photovoltaic module. Reabsorption of the converted light plays a major role in the energy losses observed in these concentrators.

The transfer ratio between the incident light intensity and the intensity received by the photovoltaic module is significantly limited by these reabsorption effects.

In current luminescent concentrators, reabsorption occurs both within the luminescent materials and through scattering in the transparent substrate.

For these reasons, the luminescent solar panel is currently intrinsically energy-inefficient.

### c1. TECHNICAL SOLUTION

The proposed solution consists in the development of an enhanced luminescent solar concentrator panel, which not only exploits the phenomenon of luminescence, but also captures all the incident energy without allowing dispersion through to the opposite surface (i.e., it is non-semitransparent).

This feature is achieved through a **concentrating effect,** generated by a conical or funnel-shaped structure that focuses the incoming light rays to better direct solar radiation. At the same time, **total internal reflection** ensures that the energy remains confined within the concentration zone.

### d. BRIEF DESCRIPTION OF THE DRAWINGS

**FIG. 1** - General side view of the enhanced luminescent solar concentrator panel, showing the main structural components of the invention: the transparent outer layer, the intermediate internal section made of a diffusive pigment with a reflective concentration zone, the reflective base, and the lateral photovoltaic cells.
**FIG. 2** - More detailed side view of the enhanced luminescent solar concentrator panel, highlighting the transparent section, the diffusive layer, the intermediate zone formed by multiple internally reflective focusing cones, the intermediate reflective layer, the bottom reflective base, and the solar cells for electric energy production.
**FIG. 3** - Top view of the panel showing the luminescent solar concentrator plate and the photovoltaic cells positioned along the four edges of the panel.
**FIG. 4** - Top and side views of the internal section of the panel showing the cones placed side by side, forming a honeycomb-like structure that constitutes the intermediate light-concentration zone.

### LEGEND - SYMBOLS AND FIGURE REFERENCES

1. Transparent external structure of the panel
   1a. Panel section made of transparent material
   1b. Panel section made of transparent material
2. Intermediate section made of a diffusive pigment with an underlying reflective concentration zone
   2a. Layer of composite diffusive and/or luminescent and/or semitransparent pigment
   2b. Hollow zone within the transparent material to create an optical lens with the surrounding transparent material
   2c. Inner wall of the conical and/or funnel-shaped reflective structure
3. Intermediate reflective layer of the panel
4. Lateral photovoltaic strip for electric energy production
5. Lateral photovoltaic strip for electric energy production
6. Lateral photovoltaic strip for electric energy production
7. Lateral photovoltaic strip for electric energy production
8. Reflective base of the panel
9. Honeycomb structure of the adjacent cones
   9a. Side view of the cone structure
   9b. Side view of the adjacent cone structure

### e. DESCRIPTION OF THE INVENTION

The purpose of the present invention is to provide a luminescent solar concentrator panel that maximizes the use of solar energy by reducing reabsorption and dispersion losses typical of luminescent concentrators for use in photovoltaic systems.

The present invention addresses these problems by focusing on its intended application: it is designed to be used as cladding for opaque surfaces, thus eliminating the need for semitransparent properties.

The invention concentrates sunlight through the synergy between a composite pigment acting as a diffusion filter-partly luminescent and partly semitransparent (filtering specific wavelengths of incident sunlight)-and a structure consisting of adjacent cones or funnels with internal reflective surfaces.

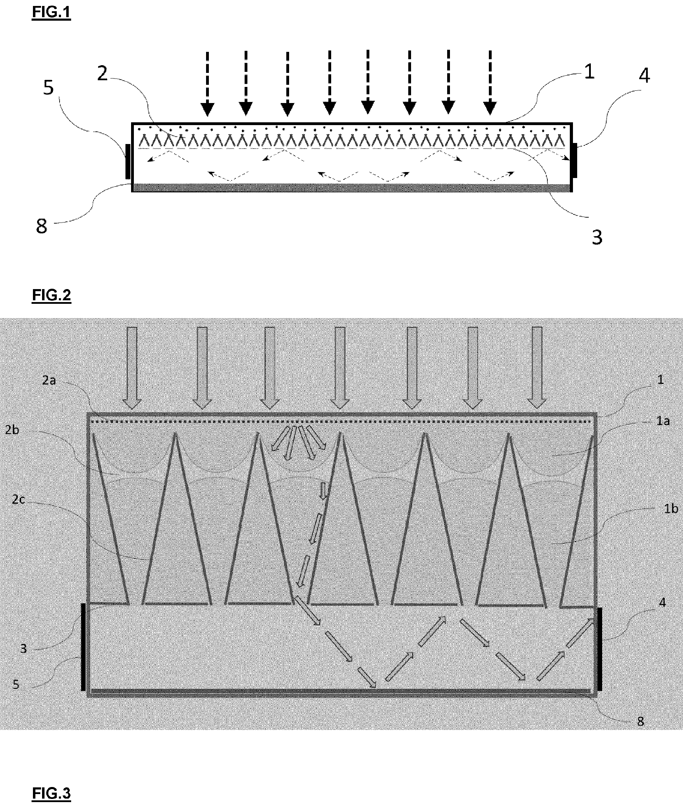

The light diffused by the composite pigment is then concentrated in the area below through reflection, using reflective cones that incorporate a specially shaped optical lens to properly direct the solar rays (Fig.1 and Fig.2).

The solar concentrator includes a diffusion and/or luminescent "filter," a reflective and focusing intermediate zone, and an energy concentration area between two reflective layers (Fig.2).

In the outermost part of the panel, directly irradiated by sunlight, a diffusely scattering, luminescent, or semitransparent material is used. The luminescent material is capable of emitting light, after absorbing it, or other radiation with sufficient quantum energy. This luminescent dye can be combined with non-luminescent diffusive material and semitransparent filter materials for specific wavelengths, such as UV rays. In one particular embodiment of this material, through synergy with the underlying reflective and focusing layers, it is possible to minimize any reabsorption of the incoming light and enable its concentration in the lower zone (Fig.2).

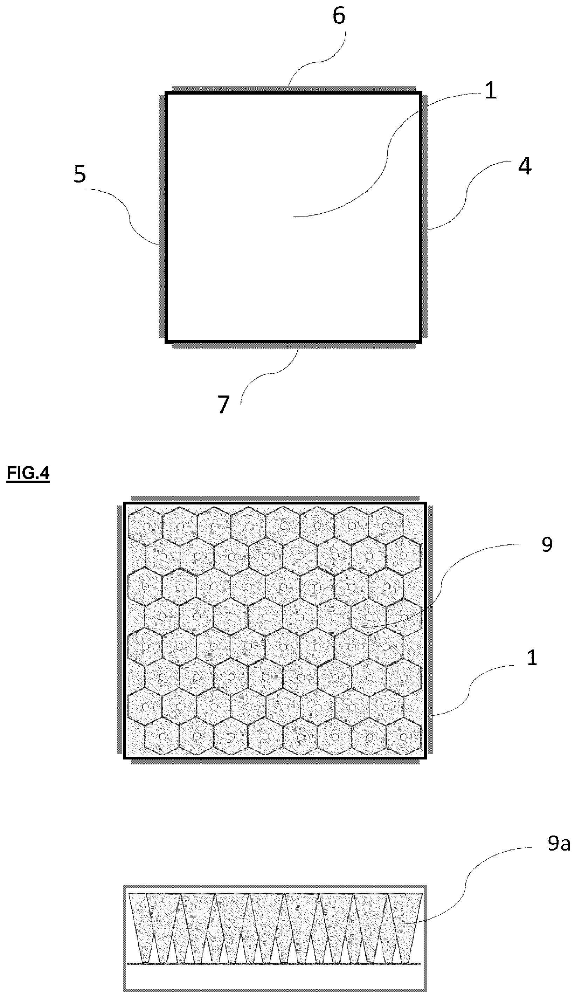

The upper part of the panel is composed of a diffusive layer that may or may not contain luminescent substances, and below it, a reflective structure arranged in a specific embodiment of adjacent cones or "funnels" (Fig.2). In particular, the internal reflective property of the cones may be achieved using mirrored chrome plating and/or metallic particles (e.g., silver or aluminum). The adjacent cone structure will have a honeycomb configuration to provide full coverage of the panel area and improve mechanical strength (Fig.4).

At the top of each cone and/or funnel is a special "optical lens," consisting of an appropriately shaped hollow zone within the transparent material. This void is shaped as a convex or biconvex lens, which has a lower refractive index compared to the surrounding transparent material (Fig.2). The effect is equivalent to a standard concave optical lens with a higher refractive index than the surrounding air. This convex or biconvex optical "lens" will be multifocal in nature, to better direct the incoming rays, focusing them from the cone's wide upper opening toward its much smaller lower opening. This hollow area shaped inside the transparent material can be produced using one or more molds through a specific procedural method.

The base of the conical structures consists of a discontinuous reflective layer, featuring openings aligned with the cones' bottom tips-points where the solar rays are concentrated. In this way, light is channeled below the discontinuous layer and remains confined "by reflection," without dispersion, in the zone between the cones' reflective base and the panel's lower reflective layer (Fig.1 and Fig.2). The discontinuous reflective layer can be made from metallic particles of aluminum or silver, from a mirrored chrome-plated material, or from a diffusive substance (e.g., BaSO₄ or TiO₂). Thus, the surface intended to be reflective can be coated with either a metallic layer or diffusive materials to provide reflectivity.

The energy concentration area can be made from any material that does not significantly interfere with the light concentrating process. Therefore, this area does not contain or consist of light-absorbing materials. It is composed of transparent material and/or empty space to avoid negatively affecting the light within the energy concentration area (Fig.1 and Fig.2).

In the concentration zone, thanks to the use of non-absorbing material, energy losses are minimized. Additionally, both the upper and lower layers have fully reflective properties, allowing the solar concentrator to advantageously increase the overall efficiency of a solar cell or any photovoltaic device connected to its area.

At the base of the solar concentrator panel, a reflective surface is used to prevent energy dispersion, considering the panel's role in contributing to energy production. This surface must be reflective and can therefore be coated with a metallic layer with or without diffusive substances. The reflective base can be made from metallic particles such as aluminum or silver, from a mirrored chrome-plated layer, or from a diffusive substance (e.g., BaSO₄ or TiO₂). Therefore, the base may be covered with a metallic or diffusive coating to achieve maximum reflectivity.

The deposition of the various substances may be carried out in a deposition chamber, such as a pulsed laser deposition (PLD) chamber, or using sputtering techniques. This type of deposition is advantageous because it enables the creation of a precisely defined composition with an exact density, resulting in high and well-defined quality that improves performance against incident solar radiation. The conical structure, including the discontinuous reflective base, can be manufactured through stereolithography, CNC machining, or molding, and placed inside the transparent material.

In one specific embodiment, the luminescent concentrator includes a photovoltaic device laterally connected to the energy concentration area. A photovoltaic device may be a module or an interconnected array of photovoltaic cells, or even a single photovoltaic/solar cell. These cells convert the sun's light energy (photons) into electrical energy through the "photovoltaic effect." Solar cells of various types can be used, including crystalline or amorphous silicon wafers or thin films, or perovskite-based cells.

Thanks to the connection of the solar concentrator to the photovoltaic device, the incident sunlight concentrated in the various layers of the panel is directed to the photovoltaic cell for conversion into electricity. The arrangement of the reflective parts, together with the different refractive indices of the involved layers, helps make the light's angle of incidence more perpendicular to the photovoltaic surfaces (Fig.2). In this way, by concentrating the incident light and optimizing the perpendicular angle of incidence on the lateral walls, the use of photovoltaic cells is optimized, increasing the overall system efficiency.

In its particular embodiment, the connection between the luminescent concentrator and the photovoltaic device is made in such a way as to be "optical" in nature, avoiding the use of materials that could reduce its efficiency.

According to the present invention, a method is provided for concentrating solar energy and converting it into electrical energy.
The method includes several steps: allowing the incident solar light to pass through a diffusion/luminescent "filter"; channeling the light rays through a structure composed of adjacent cones, each topped with a directional "lens"; concentrating the light into a lower energy concentration area between two reflective zones so it can be directed toward the side walls.

In our particular embodiment, once the light has been concentrated, it is directed onto a photovoltaic device for conversion into electrical energy.

### f. INDUSTRIAL APPLICABILITY

The present invention is innovative with respect to the prior art as it enables the realization of an enhanced luminescent solar concentrator (LSC) panel that absorbs the entirety of incident solar energy, without requiring semitransparent properties, and maximizes electrical energy production.

This application is particularly effective for use as a cladding system on opaque ("non-glazed") building surfaces, enabling the generation of green electrical energy on any type of structure.

This result is achieved without the need for expensive materials or complex equipment, owing to the synergistic integration of the system's constituent components. As such, the invention is well-suited for immediate industrial implementation.

## Claims

1. This is a concentrator solar panel (Fig.1 and Fig.2) for sunlight, composed of:
• a transparent layer which is internally composed of several sub-layers with different functions, and which includes:
∘ a diffusive and/or luminescent and/or semi-transparent layer in the outermost part, in correspondence with the surface from which the sun's rays come;
∘ an intermediate zone below the diffusive layer, consisting of:
- a structure, which has multiple cells made up of cones or funnels with reflective internal sides, with the function of conveying the sun's rays towards an underlying concentration zone;
- optical "lenses" at the top of each cone or funnel to direct the sun's rays;
- a discontinuous reflective layer to prevent the return energy from escaping, that closes the space between the bases of the cones, leaving only the internal area of the cones' base "passing through";
• photovoltaic cells positioned at the lateral edges of the transparent layer;
• a fully reflective layer at the base of the transparent part.

2. As claimed in claim 1, the luminescent solar concentrator panel has a surface of transparent material, which is directly radiated by the solar rays (Fig.1 e Fig.2).

3. As claimed in claim 1, the base of the panel consists of a layer that is capable of reflecting the whole incident solar radiation, and the reflecting layer can be flat in shape or in a particular embodiment, which increases the reflection's angle of the incident radiation (Fig.1 and Fig.2).

4. As claimed in claim 1 and 2, the part that lies on the panel's surface, the one that is hit by sunlight, is "doped" with a composite pigment in a particular embodiment and composed by diffusive and/or luminescent and/or semi-transparent material with filters for certain wavelengths (Fig.2).

5. As claimed in claim 1, under the diffusive pigment layer there is an intermediate zone consisting of a set of conical or "funnel" structures positioned side by side which covers the whole area of the panel:
- with the internal parts of these conical or "funnel" structures with reflective properties, which allow the incoming incident light to be conveyed towards the small lower opening
- with the light remaining concentrated in the lower area of the panel (Fig. 2 and Fig. 4)

6. As claimed in claim 1, 3 and 5, the structure at the base of the cones is constituted by a discontinuous reflecting layer, which has openings at the bases of the conical structures, the point where the solar rays are concentrated:
- in this way, the light is conveyed below the discontinuous layer and cannot be dispersed, remaining confined "by reflection" in the area between the discontinuous reflective layer at the cones' base and the lower layer of the panel, which is also reflective;
- this bottom area can be empty to facilitate the ray's propagation. (Fig.1 e Fig.2).

7. As claimed in claim 1 and 5, in the upper part of each conical or funnel-shaped structure a particular "optical lens" is positioned, consisting of a suitably shaped empty area inside the transparent material:
- with the empty area shaped in the form of a convex or biconvex lens, with a lower refractive index than the surrounding transparent material (*equivalent effect of a "standard" concave optical lens, which has a higher refractive index than the surrounding air*); (Fig.2)
- therefore thanks to this multifocal convex or biconvex optical "lens", it will be possible to concentrate and to direct the incident rays, from the upper opening of the cone towards the lower opening, which is much smaller.

8. As claimed in claim 1, 3 and 6, the light, concentrated between the discontinuous reflecting layer under the conical structures and the reflecting base of the panel, is transferred to the lateral sides where photovoltaic cells are positioned, by reflection, transforming this energy into electricity (Fig.1 and Fig.2).

9. As claimed in claim 1 and 5, the cones present in the intermediate layer, which are placed side by side, can have a hexagonal section in the upper junction part between the cones. In this way, the intermediate structure, view from the top, has a "honeycomb" geometry, which is useful to a complete coverage of the panel area and for improving the mechanical strength of the panel (Fig.4).

10. As claimed in claim 1, 4, 5, 8 and 9 the function of the luminescent solar panel to reflect the sunlight, concentrating it towards the lateral solar cell strips, allows to:
• absorb most of the light, minimizing dispersion;
• produce electricity
